# EUROPEAN PATENT APPLICATION

(11) **EP 4 823 282 A1**
(43) Date of publication of application: **14.10.2026**
(21) Application number: 25744482.8
(22) Date of filing: 14.01.2025
(51) Int. Cl.: H10F 77/12

(54) **SOLAR CELL AND MANUFACTURING METHOD THEREFOR**

(30) Priority: 23.01.2024 CN 202410092536; 16.08.2024 CN 202411131776; 03.09.2024 CN 202411230518
(71) Applicant: Longi Green Energy Technology Co., Ltd., Xi'an, Shaanxi 710100 (CN)
(72) Inventor: XU, Xixiang, Shaanxi 710100 (CN); YU, Mingzhe, Shaanxi 710100 (CN); DENG, Xiaoyu, Shaanxi 710100 (CN); WEI, Yanmin, Shaanxi 710100 (CN); CHEN, Yueqing, Shaanxi 710100 (CN); SUN, Zhaoqing, Shaanxi 710100 (CN); TANG, Xiyan, Shaanxi 710100 (CN); WU, Hua, Shaanxi 710100 (CN); FANG, Liang, Shaanxi 710100 (CN)
(74) Representative: Grünecker Patent- und Rechtsanwälte PartG mbB
(86) International application number: PCT/CN2025/072313
(87) International publication number: WO 2025/157039

(57) **Abstract**

The present application discloses a solar cell and a manufacturing method therefor, and relates to the field of photovoltaic technologies, to increase an electrical conductivity and an effective doping concentration of a first part of a first semiconductor layer that covers at least a part of a top of a quasi-pyramid, and reduce a transmission loss of transmitting carriers collected in the first semiconductor layer to a conductive material. The solar cell includes a semiconductor substrate and a first semiconductor layer. The semiconductor substrate includes a first surface and a second surface that are opposite to each other. At least one of the first surface and the second surface is a target surface. A surface of at least a partial region of the target surface is a textured surface, and the textured surface includes a plurality of quasi-pyramids. The plurality of quasi-pyramids include first quasi-pyramids. The first semiconductor layer is arranged on the textured surface. A material of the first semiconductor layer includes amorphous silicon and/or nanocrystalline silicon. The first semiconductor layer includes a first part covering tops of the first quasi-pyramids and a second part covering bases of the first quasi-pyramids, and a degree of crystallization of the first part is greater than a degree of crystallization of the second part.

## Description

### CROSS-REFERENCE TO RELATED APPLICATIONS

The present application claims priority to Chinese Patent Application No. 202410092536.4, filed with the China National Intellectual Property Administration on January 23, 2024 and entitled "SOLAR CELL AND MANUFACTURING METHOD THEREFOR, AND SOLAR MODULE", Chinese Patent Application No. 202411131776.7, filed with the China National Intellectual Property Administration on August 16, 2024 and entitled "SOLAR CELL AND MANUFACTURING METHOD THEREFOR", and Chinese Patent Application No. 202411230518.4 field with the China National Intellectual Administration Property on September 03, 2024 and entitled "SOLAR CELL AND MANUFACTURING METHOD THEREFOR", which are incorporated herein by reference in their entireties.

### TECHNICAL FIELD

The present application relates to the field of photovoltaic technologies, and in particular, to a solar cell and a manufacturing method therefor.

### BACKGROUND

A solar cell is an apparatus that can convert sun's light energy into electric energy. Specifically, when the solar cell is in an operating state, sunlight irradiates onto a semiconductor p-n junction of the solar cell to form new hole-electron pairs. Under an action of a built-in electric field of the p-n junction, photogenerated holes flow to a p-type region, and photogenerated electrons flow to an n-type region, so that a current can be generated when a circuit is powered on. The amorphous silicon material and the nanocrystalline silicon material contain hydrogen, so that a dangling bond on the surface of the semiconductor substrate can be hydrogenated, and surface defects can be reduced, thereby having a high passivation effect on the semiconductor substrate. Therefore, when the material of the semiconductor layer in the solar cell includes amorphous silicon and/or nanocrystalline silicon, the carrier recombination rate is reduced.

However, in an existing solar cell, a contact resistance between a semiconductor layer of which a material includes amorphous silicon and/or nanocrystalline silicon and a conductive material (a transparent conductive layer or an electrode) is large, and the transmission loss is high, which is not beneficial to improving the work efficiency of the solar cell.

### SUMMARY

An objective of the present application is to provide a solar cell and a manufacturing method therefor, to increase an electrical conductivity and an effective doping concentration of a first part of a first semiconductor layer that covers a top of a first quasi-pyramid, reduce a contact resistance between the first semiconductor layer and a conductive material (a transparent conductive layer or an electrode), further reduce a transmission loss of transmitting carriers collected in the first semiconductor layer to the conductive material, and improve the work efficiency of the solar cell.

To achieve the foregoing objective, according to a first aspect, the present application provides a solar cell. The solar cell includes: a semiconductor substrate and a first semiconductor layer. The semiconductor substrate includes a first surface and a second surface that are opposite to each other. At least one of the first surface and the second surface is a target surface. A surface of at least a partial region of the target surface is a textured surface, and the textured surface includes a plurality of quasi-pyramids. The plurality of quasi-pyramids include first quasi-pyramids. The first semiconductor layer is arranged on the textured surface. A material of the first semiconductor layer includes amorphous silicon and/or nanocrystalline silicon. The first semiconductor layer includes a first part covering tops of the first quasi-pyramids and a second part covering bases of the first quasi-pyramids. A degree of crystallization of the first part is greater than a degree of crystallization of the second part.

When the foregoing technical solution is used, compared with that the surface of the side of the first semiconductor layer facing away from the semiconductor substrate is a plane, when the first semiconductor layer is arranged on the textured surface, the side of the first semiconductor layer facing away from the semiconductor substrate has a fluctuation topography that is approximately the same as that of the textured surface. In this case, the first semiconductor layer has a larger specific surface area, which can increase a contact area between the first semiconductor layer and a conductive material (a transparent conductive layer, an electrode, or the like), and reduce a transmission loss of transmitting carriers collected in the first semiconductor layer to the conductive material. In addition, it may be understood that, when other factors are the same, a smaller degree of crystallization of the semiconductor layer indicates smaller grains in the semiconductor layer, and even the randomness of an amorphous silicon material is presented. However, smaller grains in the semiconductor layer indicates more interfaces between the grains in the semiconductor layer, leading to large resistance at an interface between the grains. In addition, in an actual manufacturing process, crystallization treatment is usually performed on the semiconductor layer at a high temperature, to improve a degree of crystallization of the semiconductor layer; while a semiconductor layer having smaller grains is sensitive to a temperature, and an effective doping concentration of the semiconductor layer obtained at a low doping temperature is also low. Therefore, compared with a case that the degree of crystallization of the part of the first semiconductor layer covering the top of the quasi-pyramid is as low as the degree of crystallization of the part of the first semiconductor layer covering the base of the quasi-pyramid, in the solar cell provided in the present application, when the degree of crystallization of the first part of the first semiconductor layer covering the tops of the first quasi-pyramids is greater than the degree of crystallization of the second part of the first semiconductor layer covering the bases of the first quasi-pyramids, the quantity of interfaces between grains in the first part of the first semiconductor layer covering the tops of the first quasi-pyramids is reduced, and the transmission resistance of the first part is reduced. In addition, in this case, crystallization treatment may be performed on the first part included in the first semiconductor layer at a high temperature, so that more dopants can be doped into the first part included in the first semiconductor layer, thereby facilitating an increase in an effective doping concentration of the first part included in the first semiconductor layer, improving the electrical conductivity of the first part included in the first semiconductor layer, and reducing the contact resistance between the first semiconductor layer and the conductive material (a transparent conductive layer or an electrode), thereby facilitating reduction in the transmission loss from transmitting the carriers collected in the first semiconductor layer to the conductive material. In addition, in the first semiconductor layer, at least the second part of the first semiconductor layer that covers the bases of the first quasi-pyramids has a small degree of crystallization. In a case of crystallization treatment at a reduced temperature, at least the second part has a high content of hydrogen, so that at least the second part has a high passivation effect on the textured surface, thereby reducing the number of defects of the textured surface, and improving the work efficiency of the solar cell. In short, the first part with a large degree of crystallization is formed by treating the tops of the first quasi-pyramids, which can ensure that the contact resistance between the conductive material and the first semiconductor layer is lowered. However, meanwhile, the first part with a large degree of crystallization cannot be excessively large. That is, the second part on the bases of the first quasi-pyramids has a low degree of crystallization, which can ensure a passivation effect of the first semiconductor layer. That is, a balance between the contact resistance and the passivation effect is considered.

In a possible implementation solution, in the first semiconductor layer, a material of the first part includes nanocrystalline silicon; and a material of the second part includes amorphous silicon.

When the foregoing technical solution is used, when other factors are the same, compared with nanocrystalline silicon, a degree of crystallization of the amorphous silicon material is lower, and the amorphous silicon material is affected little by heat in a crystallization treatment process, so that the content of hydrogen in the amorphous silicon material is high. Based on this, in the first semiconductor layer, when the material of the second part includes amorphous silicon, the second part contains much hydrogen, a dangling bond on the surface of the semiconductor substrate is hydrogenated, and surface defects are reduced, thereby having a high passivation effect on the semiconductor substrate. However, in the first semiconductor layer, when the material of the first part includes nanocrystalline silicon, at least the first part of the first semiconductor layer that has a larger degree of crystallization has a high electrical conductivity and an effective doping concentration, to reduce a contact resistance between the first part of the first semiconductor layer and a conductive material (a transparent conductive layer or an electrode), and further reduce a transmission loss of transmitting carriers collected in the first semiconductor layer to the conductive material.

In a possible implementation solution, the first part of the first semiconductor layer contains grains, and a maximum size of the grains is less than a thickness of the first part.

When the foregoing technical solution is used, during actual manufacturing, a larger size of grains in the first part of the first semiconductor layer indicates a higher temperature for performing crystallization treatment on the first part of the first semiconductor layer. However, a higher treatment temperature indicates a larger amount of evolved hydrogen in the first part of the first semiconductor layer, and consequently, the passivation effect of the first part of the first semiconductor layer on the semiconductor substrate is reduced. Therefore, compared with that the maximum size of the grains in the first part of the first semiconductor layer is equal to the thickness of the first part, when the maximum size of grains in the first part of the first semiconductor layer is less than the thickness of the first part, crystallization temperature corresponding to the first semiconductor layer is low, so that the first part of the first semiconductor layer has high electrical conductivity and an effective doping concentration, and a transmission loss between the first part of the first semiconductor layer and the conductive material is reduced. In this way, a part, in which no grain extendedly grows, of the first semiconductor layer has a high passivation effect on the semiconductor substrate, and a balance between the passivation effect and the transmission loss that correspond to the first semiconductor layer is achieved, to further improve work performance of the solar cell.

In a possible implementation solution, a crystallization depth of the first part of the first semiconductor layer is less than a thickness of the first part. For a beneficial effect and an application principle in this case, reference may be made to the foregoing beneficial effect and application principle that the maximum size of the grains in the first part of the first semiconductor layer is less than the thickness of the first part, and details are not described herein again.

In a possible implementation solution, a crystallization depth of the first part of the first semiconductor layer is gradually reduced along a direction from the laterally inclined direction of each of the quasi-pyramids to the base of the quasi-pyramid. In this case, when crystallization treatment is performed on at least a part of the first semiconductor layer, a treatment temperature of each part of the first semiconductor layer covering the quasi-pyramid is gradually reduced along the direction from the laterally inclined direction of each of the quasi-pyramids to the base of the quasi-pyramid. When the first part of the first semiconductor layer has high electrical conductivity and an effective doping concentration, impact of a high temperature of the crystallization treatment on the remaining part of the first semiconductor layer is reduced, to ensure that the remaining part of the first semiconductor layer has a high hydrogen content, so that the remaining part of the first semiconductor layer has a high passivation effect on the semiconductor substrate.

In a possible implementation solution, along a laterally inclined direction of each of the quasi-pyramids, a ratio of a maximum extension length of the first part on a side of each of the first quasi-pyramids located below the first part to a length of the side of each of the first quasi-pyramids is less than or equal to 0.3.

When the foregoing technical solution is used, as described above, although the first part included in the first semiconductor layer can reduce the transmission loss between the first semiconductor layer and the conductive material, the first part of the first semiconductor layer has a small content of hydrogen, so that the first part has a weak passivation effect on the semiconductor substrate (compared with the second part). Based on this, when the ratio of the maximum extension length of the first part of the first semiconductor layer on the side of each of the first quasi-pyramids located below the first part to the length of the side of each of the first quasi-pyramids is less than or equal to 0.3 along the laterally inclined direction of the first quasi-pyramid, a part (including the second part) of the first semiconductor layer having a high passivation effect can have a large coverage of the textured surface, thereby further reducing the quantity of surface defects of the textured surface. In addition, in an actual manufacturing process, a heating rate of the top of the quasi-pyramid is higher than a heating rate of the base of the quasi-pyramid, and more heat is more easily accumulated at the top of the quasi-pyramid, so that the quasi-pyramid has a higher degree of crystallization. Based on this, when the ratio of the maximum extension length of the first part of the first semiconductor layer on the side of each of the first quasi-pyramids located below the first part to the length of the side of each of the first quasi-pyramids is less than or equal to 0.3 along the laterally inclined direction of the first quasi-pyramid, a case that an extension length of the first part of the first semiconductor layer above the first quasi-pyramid is large and consequently the part of the first semiconductor layer that is at the tops of the first quasi-pyramids is excessively hot to affect the passivation effect of the first semiconductor layer can be avoided, to ensure that the first part of the first semiconductor layer that is at the tops of the first quasi-pyramids also has a particular passivation effect, thereby further improving the work efficiency of the solar cell.

In a possible implementation solution, a thickness of the first semiconductor layer is greater than or equal to 10 nm, and/or a thickness of the first semiconductor layer is less than or equal to 45 nm. In this case, a lower limit and/or an upper limit of the thickness of the first semiconductor layer of which the material includes the amorphous silicon and/or the nanocrystalline silicon is larger, which reduces thermal impact of heat on the semiconductor substrate by using the first semiconductor layer having a larger thickness, thereby preventing thermal damage from being caused to the semiconductor substrate in a process in which crystallization treatment is performed on at least a part of the first semiconductor layer, and ensuring that the solar cell has a high yield. In addition, the first semiconductor layer having a larger thickness has a high passivation effect, which can further reduce a carrier recombination rate at the textured surface, thereby further improving the work efficiency of the solar cell.

In a possible implementation solution, the solar cell further includes a transparent conductive layer, and the transparent conductive layer covers at least a side of the first semiconductor layer that faces away from the semiconductor substrate. In this case, the transparent conductive layer has a high conductivity, so that carriers collected by the first semiconductor layer may be exported in time, thereby reducing a carrier recombination rate.

In a possible implementation solution, the quasi-pyramids are pyramids having a sharp vertex angle; or the quasi-pyramids are quasi-pyramids having a rounded chamfer; or the quasi-pyramids are quasi-pyramids having a truncated vertex angle. In this case, the quasi-pyramid may have at least the foregoing three examples, so that applicability of the solar cell provided in the present application in different application scenarios can be improved. In addition, the manufacturing precision does not need to be strictly controlled to obtain quasi-pyramids having a single topography, thereby reducing the process difficulty, and facilitating an improvement in the yield of the solar cell.

In a possible implementation solution, surfaces of the quasi-pyramids are planes. In this case, compared with that the surfaces of the quasi-pyramids are bumpy surfaces, when the surfaces of the quasi-pyramids are planes, a fluctuation degree of the quasi-pyramid is low, so that the first semiconductor layer deposited on the textured surface has a large thickness, thereby further improving a high passivation effect of the first semiconductor layer.

In a possible implementation solution, a surface roughness of the first part of the first semiconductor layer is greater than a surface roughness of the second part. In this case, the first part of the first semiconductor layer has a larger specific surface area, which increases the contact area between the first part and the conductive material, reduces the contact resistance between the first part and the conductive material, further reduces the transmission loss of transmitting the carriers to the conductive material through the first semiconductor layer, and further improves the work efficiency of the solar cell. In addition, in an actual manufacturing process, laser illumination, high-temperature annealing, or the like needs to be used to implement crystalline modification of a part of the first semiconductor layer. However, a heating rate of the top of the quasi-pyramid is higher than a heating rate of the base of the quasi-pyramid, and crystalline modification is easier to be implemented. In addition, the change of the surface roughness of the first part is related to the change of the degree of crystallization of the first part and the evolution of hydrogen in the first part. Based on this, when the surface roughness of the first part is greater than the surface roughness of the second part, each part of the first semiconductor layer does not need to be heated for a long time to cause the second part of the first semiconductor layer covering the bases of the first quasi-pyramids to also have a large surface roughness, which otherwise causes dehydrogenation, thereby ensuring a high passivation effect of the first semiconductor layer.

In a possible implementation solution, the first semiconductor layer includes a first intrinsic semiconductor layer and a first doped semiconductor layer. The first doped semiconductor layer is arranged on a side of the first intrinsic semiconductor layer that faces away from the semiconductor substrate. In addition, along a direction toward the textured surface, the maximum size of the grains contained in the first part of the first semiconductor layer is less than or equal to a thickness of the first doped semiconductor layer; and/or a crystallization depth of the first part of the first semiconductor layer is less than or equal to a thickness of the first doped semiconductor layer.

When the foregoing technical solution is used, the first intrinsic semiconductor layer and the first doped semiconductor layer may form a selective contact structure, which has an excellent interface passivation effect, and can selectively collect carriers, so that a carrier recombination rate of a region on which the first semiconductor layer is formed on the semiconductor substrate is reduced, and the photoelectric conversion efficiency of the solar cell is further improved. Secondly, along a direction toward the textured surface, the maximum size of the grains contained in the first part of the first semiconductor layer is less than or equal to a thickness of the first doped semiconductor layer. In this case, the part of the first intrinsic semiconductor layer corresponding to the largest grain still has a passivation effect on the semiconductor substrate, which can further reduce the carrier recombination rate. Secondly, for a beneficial effect and an application principle of that the crystallization depth of the first part of the first semiconductor layer is less than or equal to the thickness of the first doped semiconductor layer, reference may be made to the foregoing descriptions, and details are not described herein again.

In a possible implementation solution, the solar cell further includes a second semiconductor layer having a conductivity type opposite to that of the first semiconductor layer. The second semiconductor layer and the first semiconductor layer are arranged on a same surface of the semiconductor substrate, and the first semiconductor layer extends to cover a part of a side of the second semiconductor layer that faces away from the semiconductor substrate; and/or the second semiconductor layer is arranged on the second surface of the semiconductor substrate, and a material of the second semiconductor layer includes at least one of polycrystalline silicon, amorphous silicon, nanocrystalline silicon, and microcrystalline silicon.

If the foregoing technical solution is used, when the second semiconductor layer and the first semiconductor layer are arranged on a same surface of the semiconductor substrate, the solar cell provided in the present application is a back contact cell, which can reduce impact of a light-shielding electrode structure on the utilization of light on a side of a light receiving surface, and further improve the photoelectric conversion efficiency of the solar cell. In addition, when a material of the second semiconductor layer includes at least one of polycrystalline silicon, amorphous silicon, nanocrystalline silicon, and microcrystalline silicon, there is a plurality of possible examples of a material of the second semiconductor layer, so that applicability of the solar cell provided in the present application in different application scenarios can be improved.

According to a second aspect, the present application provides a manufacturing method for a solar cell. The manufacturing method for a solar cell includes: A semiconductor substrate is provided. The semiconductor substrate has a first surface and a second surface that are opposite to each other. At least one of the first surface and the second surface is a target surface. A surface of at least a partial region of the target surface is a textured surface. The textured surface includes a plurality of quasi-pyramids, and the plurality of quasi-pyramids includes first quasi-pyramids. Next, a first semiconductor layer is formed on the textured surface, where a material of the first semiconductor layer includes amorphous silicon and/or nanocrystalline silicon. The first semiconductor layer includes a first part covering tops of the first quasi-pyramids and a second part covering bases of the first quasi-pyramids, and a degree of crystallization of the first part is greater than a degree of crystallization of the second part.

In a possible implementation solution, crystallization treatment is performed on at least a part of the first semiconductor layer by using a laser illumination process, to cause a degree of crystallization of the first part of the first semiconductor layer to be greater than a degree of crystallization of the second part of the first semiconductor layer.

In a possible implementation solution, a wave length of laser used in the laser illumination process is greater than or equal to 325 nm and less than or equal to 532 nm; and/or a pulse width of the laser illumination process is on an order of picoseconds or nanoseconds; and/or a laser energy density of the laser illumination process is greater than or equal to 200 mJ/cm² and less than or equal to 6000 mJ/cm².

For beneficial effects of the second aspect and various implementations of the second aspect in the present application, refer to the analysis of the beneficial effects of the first aspect and various implementations of the first aspect. Details are not described herein again.

### BRIEF DESCRIPTION OF THE DRAWINGS

The accompanying drawings described herein are used to provide a further understanding of the present application, and form a part of the present application. Exemplary embodiments of the present application and description thereof are used to explain the present application, and do not constitute any inappropriate limitation to the present application. In the accompanying drawings:
FIG. 1 is a schematic longitudinal cross-sectional view of a first structure of a solar cell according to an embodiment of the present application;
FIG. 2 is an SEM image of a partial structure at a single quasi-pyramid in a solar cell according to an embodiment of the present application;
FIG. 3 is a partial enlarged TEM image of an region framed by a bold rectangular solid line in FIG. 2 at a first magnification;
FIG. 4 is a partial enlarged TEM image of an region framed by a bold rectangular solid line in FIG. 2 at a second magnification;
FIG. 5 is a partial enlarged TEM image of an region framed by a rectangular dashed line in FIG. 2;
FIG. 6 is a partial enlarged TEM image of an region framed by a thin rectangular dashed line in FIG. 2;
FIG. 7 is an SEM image of a partial structure at a plurality of quasi-pyramids in a solar cell according to an embodiment of the present application;
FIG. 8 is a schematic longitudinal cross-sectional view of a second structure of a solar cell according to an embodiment of the present application;
FIG. 9 is a schematic longitudinal cross-sectional view of a third structure of a solar cell according to an embodiment of the present application;
FIG. 10 is a schematic longitudinal cross-sectional view of a fourth structure of a solar cell according to an embodiment of the present application;
FIG. 11 is a schematic longitudinal cross-sectional view of a fifth structure of a solar cell according to an embodiment of the present application;
FIG. 12 is a schematic longitudinal cross-sectional view of a sixth structure of a solar cell according to an embodiment of the present application;
FIG. 13 is a schematic diagram of a result of a type of quasi-pyramid topography in a solar cell according to an embodiment of the present application;
FIG. 14 is a schematic diagram of a result of another type of quasi-pyramid topography in a solar cell according to an embodiment of the present application;
FIG. 15 is a schematic longitudinal cross-sectional view of a seventh structure of a solar cell according to an embodiment of the present application;
FIG. 16 is a schematic longitudinal cross-sectional view of an eighth structure of a solar cell according to an embodiment of the present application;
FIG. 17 is a schematic longitudinal cross-sectional view of a ninth structure of a solar cell according to an embodiment of the present application;
FIG. 18 is a schematic longitudinal cross-sectional view of a tenth structure of a solar cell according to an embodiment of the present application;
FIG. 19 is a schematic longitudinal cross-sectional view of an eleventh structure of a solar cell according to an embodiment of the present application;
FIG. 20 is a schematic longitudinal cross-sectional view of a twelfth structure of a solar cell according to an embodiment of the present application; and

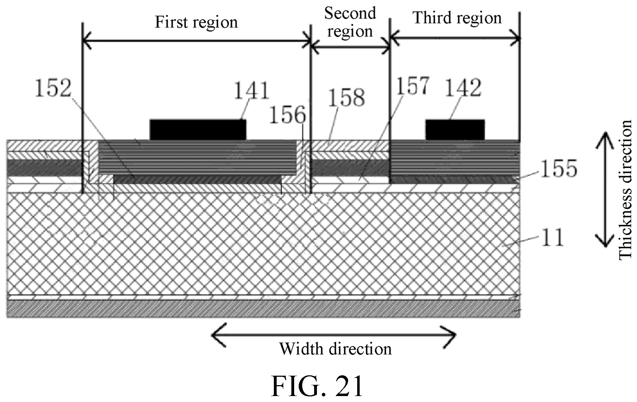

FIG. 21 is a schematic diagram of a partial structure of a solar cell according to an embodiment of the present application.

Reference numerals: 11 is a semiconductor substrate, 12 is a target surface, 13 is a quasi-pyramid, 14 is a first semiconductor layer, 15 is a first part, 16 is a second part, 17 is a transparent conductive layer, 18 is a first intrinsic semiconductor layer, 19 is a first doped semiconductor layer, 20 is a second semiconductor layer, 21 is an insulation layer, 22 is an interface passivation layer, 23 is a second doped semiconductor layer, 141 is a first electrode, 142 is a second electrode, 152 is a first crystalline region, 155 is a second crystalline region, 156 is a first amorphous region A, 157 is a second amorphous region B, and 158 is a first amorphous region B.

### DETAILED DESCRIPTION

Embodiments of the present application are described below with reference to the accompanying drawings. However, it should be understood that descriptions are merely examples, and are not intended to limit the scope of the present application. In addition, descriptions of well-known structures and technologies are omitted in the following descriptions, to avoid unnecessarily obscuring the concept of the present application.

The accompanying drawings show various schematic structural diagrams according to the embodiments of the present application. The figures are not drawn to scale. For an objective of more clear expression, some details are enlarged, and some details may be omitted. Shapes of various regions and layers and relative sizes and position relationships between the regions and layers shown in the figures are merely examples. In practice, there may be a deviation due to a manufacturing tolerance or a technical limitation, and a person skilled in the art may additionally design regions/layers having different shapes, sizes, and relative positions according to actual requirements.

In the context of the present application, when a layer/element is referred to as being "above" another layer/element, the layer/element may be directly above the another layer/element, or a middle layer/element may exist therebetween. In addition, if a layer/element is "on" another layer/element in a direction, when the direction is turned over, the layer/element may be "below" the another layer/element. To make the technical problems to be resolved by, the technical solutions, and the beneficial effects of the present application clearer and more comprehensible, the following describes the present application in further detail with reference to the accompanying drawings and embodiments. It should be understood that, the specific embodiments described herein are merely used for describing the present application and are not intended to limit the present application.

In addition, the terms "first" and "second" are used only for the purpose of description, and shall not be construed as indicating or implying relative importance or implicitly indicating a quantity of indicated technical features. Therefore, a feature defined by "first" or "second" may explicitly or implicitly include one or more of such features. In the descriptions of the present application, "a plurality of" means two or more, unless otherwise clearly and specifically limited. Unless otherwise clearly and specifically limited, "at least one" means one or more than one.

In the descriptions of the present application, it should be noted that, unless otherwise explicitly stipulated and restricted, terms "installation", "joint connection", and "connection" should be understood broadly, which, for example, may be a fixed connection, or may be a detachable connection, or an integral connection; or may be a mechanical connection, or may be an electrical connection; or may be a direct connection, or may be an indirect connection by using a medium, or may be an internal communication between two components, or may be an interactive relationship between two components. A person of ordinary skill in the art can understand specific meanings of the terms in the present application based on specific situations.

A solar cell is an apparatus that can convert sun's light energy into electric energy. Specifically, when the solar cell is in an operating state, sunlight irradiates onto a semiconductor p-n junction of the solar cell to form new hole-electron pairs. Under an action of a built-in electric field of the p-n junction, photogenerated holes flow to a p-type region, and photogenerated electrons flow to an n-type region, so that a current can be generated when a circuit is powered on. The amorphous silicon material and the nanocrystalline silicon material contain hydrogen, so that a dangling bond on the surface of the semiconductor substrate can be hydrogenated, and surface defects can be reduced, thereby having a high passivation effect on the semiconductor substrate. Therefore, when the material of the semiconductor layer in the solar cell includes amorphous silicon and/or nanocrystalline silicon, the carrier recombination rate is reduced.

However, compared with a semiconductor layer of which a material includes polycrystalline silicon or monocrystalline silicon with a higher degree of crystallization, an effective doping concentration of the semiconductor layer of which the material includes amorphous silicon and/or nanocrystalline silicon is low. Consequently, in an existing solar cell, the semiconductor layer of which the material includes amorphous silicon and/or Nanocrystalline silicon is not good in electrical conductivity. As a result, a transmission loss between the semiconductor layer of which the material includes amorphous silicon and/or Nanocrystalline silicon and a conductive material (a transparent conductive layer or an electrode) is high, which is not beneficial to improving work efficiency of the solar cell.

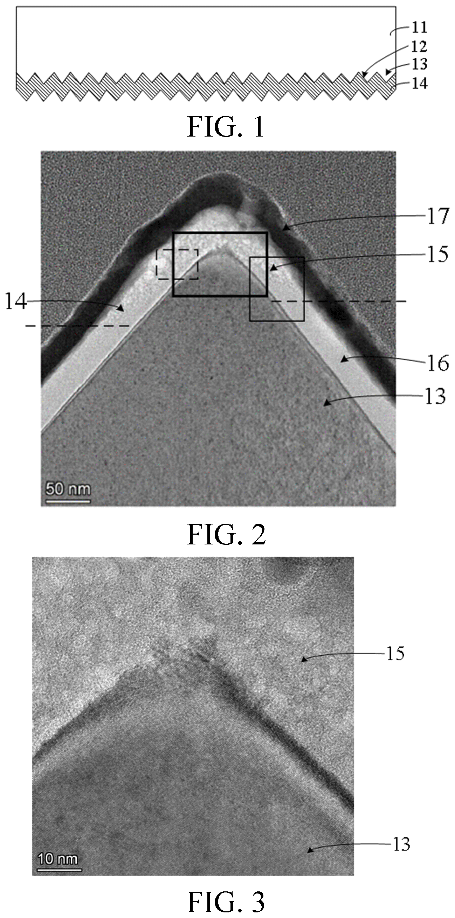

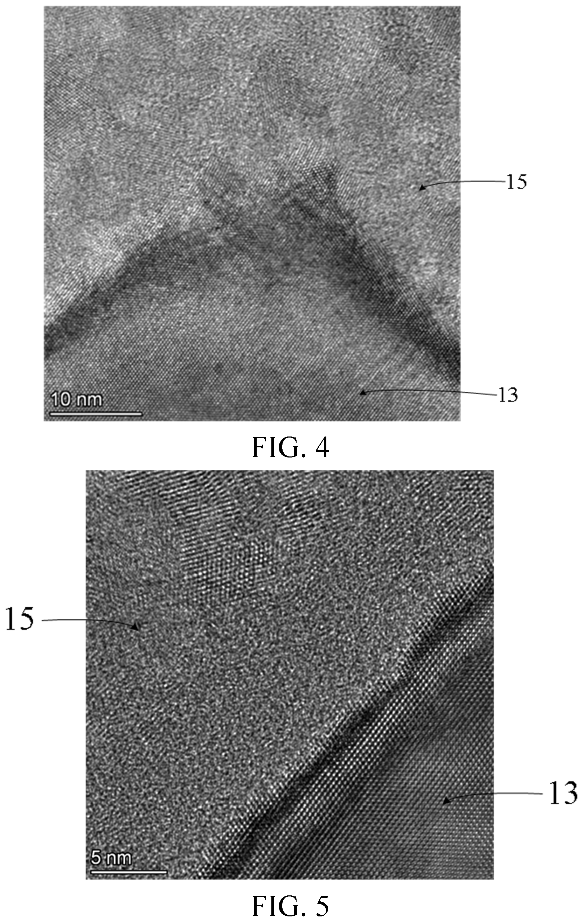

To resolve the foregoing technical problem, according to a first aspect, an embodiment of the present application provides a solar cell. As shown in FIG. 1 to FIG. 7, the solar cell includes: a semiconductor substrate 11 and a first semiconductor layer 14. The semiconductor substrate 11 includes a first surface and a second surface opposite to the first surface. At least one of the first surface and the second surface is a target surface 12. A surface of at least a partial region of the target surface 12 is a textured surface, the textured surface includes a plurality of quasi-pyramids 13, and the plurality of quasi-pyramids 13 includes first quasi-pyramids. The first semiconductor layer 14 is arranged on the textured surface. A material of the first semiconductor layer 14 includes amorphous silicon and/or nanocrystalline silicon. The first semiconductor layer 14 includes a first part 15 covering tops of the first quasi-pyramids and a second part 16 covering bases of the first quasi-pyramids. A degree of crystallization of the first part 15 is greater than a degree of crystallization of the second part 16. The quantity of the plurality of first quasi-pyramids may be a part of the plurality of quasi-pyramids 13. For example, the quantity of the plurality of first quasi-pyramids may account for 70%, 50%, or 40% of the plurality of quasi-pyramids. Specifically, the quantity of the plurality of first quasi-pyramids may be properly set according to the thickness of the first semiconductor layer and a laser condition.

As shown in FIG. 1 to FIG. 7, the first semiconductor layer 14 may fluctuate with the surface topography of the textured surface. In this case, a side of the first semiconductor layer 14 that faces away from the semiconductor substrate 11 has a fluctuation topography that is approximately the same as that of the textured surface. However, due to impact of a depositing process, the thickness of the first semiconductor layer 14 at the top of the quasi-pyramid 13 may be different from the thickness of the first semiconductor layer 14 at the base of the quasi-pyramid 13.

When the foregoing technical solution is used, as shown in FIG. 1 to FIG. 7, compared with that the surface of the side of the first semiconductor layer 14 facing away from the semiconductor substrate 11 is a plane, when the first semiconductor layer 14 is arranged on the textured surface, the side of the first semiconductor layer 14 facing away from the semiconductor substrate 11 has a fluctuation topography that is approximately the same as that of the textured surface. In this case, the first semiconductor layer 14 has a larger specific surface area, which can increase a contact area between the first semiconductor layer 14 and a conductive material (a transparent conductive layer, an electrode, or the like), and reduce a transmission loss of transmitting carriers collected in the first semiconductor layer 14 to the conductive material. In addition, it may be understood that, when other factors are the same, a smaller degree of crystallization of the semiconductor layer indicates smaller grains in the semiconductor layer, and even the randomness of an amorphous silicon material is presented. However, smaller grains in the semiconductor layer indicates more interfaces between the grains in the semiconductor layer, leading to large resistance at an interface between the grains. A larger degree of crystallization indicated in this embodiment of the present application may be a larger crystallization rate, a larger grain size, and/or a larger quantity of grains. For example, when the first semiconductor layer is a nanocrystalline silicon layer (the nanocrystalline silicon layer usually still includes an amorphous silicon part, which is inevitable, but a proportion of the amorphous silicon part is small, which is known in the art), the first part with a higher degree of crystallization has a larger crystalline volume fraction and a larger grain size than the second part. When the first semiconductor layer is made of amorphous silicon (the amorphous silicon may include a small nanocrystalline silicon part, but a proportion of the nanocrystalline silicon part is quite small, for example, less than 5%, which is known in the art), grains with ordered lattices are formed in the first part with a higher degree of crystallization, and the degree of crystallization of the first part increases. However, the second part with a lower degree of crystallization is still made of an amorphous silicon material, and does not include grains formed after laser treatment or the like.

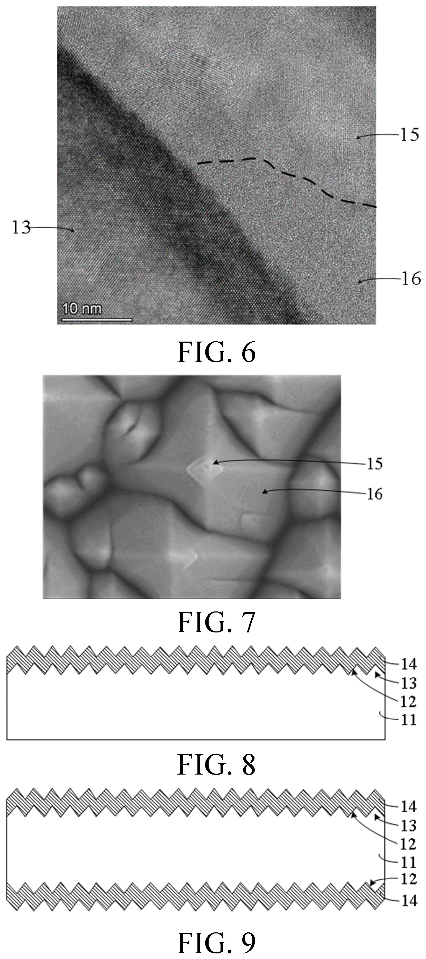

In addition, in an actual manufacturing process, crystallization treatment is usually performed on the semiconductor layer at a high temperature, to improve a degree of crystallization of the semiconductor layer; while a semiconductor layer having smaller grains is sensitive to a temperature, and an effective doping concentration of the semiconductor layer obtained at a low doping temperature is also low. Therefore, compared with a case that the degree of crystallization of the part of the first semiconductor layer covering the top of the quasi-pyramid is as low as the degree of crystallization of the part of the first semiconductor layer covering the base of the quasi-pyramid, as shown in FIG. 1 to FIG. 7, in the solar cell provided in this embodiment of the present application, when the degree of crystallization of the first part 15 of the first semiconductor layer 14 (it may be learned from FIG. 2 to FIG. 6 that, the first part 15 of the first semiconductor layer 14 contains grains, that is, at least a part of the first semiconductor layer has regular lattice distribution) is greater than the degree of crystallization of the second part 16 of the first semiconductor layer 14, the quantity of interfaces between grains in the first part 15 of the first semiconductor layer 14 is reduced, and the transmission resistance of the first part 15 of the first semiconductor layer 14 is reduced. In addition, in this case, crystallization treatment may be performed on the first part 15 of the first semiconductor layer 14 at a high temperature, so that more dopants can be doped into the first part 15 of the first semiconductor layer 14, thereby facilitating an increase in an effective doping concentration of the first part 15 of the first semiconductor layer 14, improving the electrical conductivity of the first part 15 of the first semiconductor layer 14, and reducing the contact resistance between the first semiconductor layer 14 and the conductive material (a transparent conductive layer or an electrode), thereby facilitating reduction in the transmission loss from transmitting the carriers collected in the first semiconductor layer 14 to the conductive material. In addition, in the first semiconductor layer 14, the second part 16 has a small degree of crystallization. In a case of crystallization treatment at a reduced temperature, at least the second part 16 of the first semiconductor layer 14 has a high content of hydrogen, so that at least the second part 16 of the first semiconductor layer 14 has a high passivation effect on the textured surface, thereby reducing the number of defects of the textured surface, and improving the work efficiency of the solar cell. In short, the first part 15 with a large degree of crystallization is formed by treating the tops of the first quasi-pyramids, which can ensure that the contact resistance between the conductive material and the first semiconductor layer 14 is lowered. However, meanwhile, the first part 15 with a large degree of crystallization cannot be excessively large. That is, the second part 16 on the bases of the first quasi-pyramids has a low degree of crystallization, which can ensure a passivation effect of the first semiconductor layer 14. That is, a balance between the contact resistance and the passivation effect is considered. Regarding a boundary between the first part 15 and the second part 16 in the first semiconductor layer 14, it can be seen from FIG. 6 that when a part that is in the first semiconductor layer 14 and that is close to the tops of the first quasi-pyramids and whose grain size and/or crystallization depth is greater than that of the first semiconductor layer 14 distributed above the remaining region of the first quasi-pyramid is the first part 15, an edge contour of the first part 15 is the boundary between the first part 15 and the second part 16.

In an actual application process, a material and a conductivity type of the semiconductor substrate are not specifically limited in the embodiments of the present application. For example, the semiconductor substrate may be a silicon substrate. Alternatively, the semiconductor substrate may be a silicon germanium substrate, a germanium substrate, a gallium arsenide substrate, or any other substrate made of a semiconductor material.

Secondly, the semiconductor substrate has a first surface and a second surface that are opposite to each other. The first surface of the semiconductor substrate may correspond to a light receiving surface of the solar cell. In this case, the second surface of the semiconductor substrate corresponds to a back surface of the solar cell. Alternatively, the first surface of the semiconductor substrate may correspond to a back surface of the solar cell. In this case, the second surface of the semiconductor substrate corresponds to a light receiving surface of the solar cell. In addition, because the first semiconductor layer is formed on the textured surface of the target surface, whether the first surface and the second surface of the semiconductor substrate are target surfaces may be determined according to a requirement for a forming position of the first semiconductor layer in an actual application scenario. This is not specifically limited herein.

For example, as shown in FIG. 1, FIG. 8, and FIG. 9, when the solar cell provided in this embodiment of the present application is a double-sided contact cell, in the first surface and the second surface, only the first surface may be the target surface 12, or only the second surface may be the target surface 12, or both the first surface and the second surface may be target surfaces 12. It should be noted that, as shown in FIG. 9, when both the first surface and the second surface are the target surfaces 12, the two first semiconductor layers 14 respectively formed on the first surface and the second surface have opposite conductivity types.

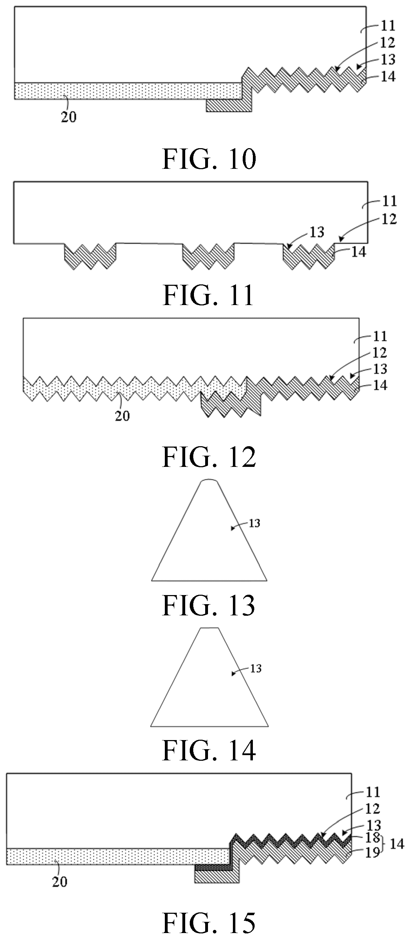

For example, as shown in FIG. 10, when the solar cell provided in this embodiment of the present application is a back contact cell, one of the first surface and the second surface that corresponds to a back surface of the solar cell is a target surface 12. Specifically, when the first surface of the semiconductor substrate 11 corresponds to the back surface of the solar cell, the first surface is the target surface 12; and when the second surface of the semiconductor substrate 11 corresponds to the back surface of the solar cell, the second surface is the target surface 12.

In addition, as shown in FIG. 10, in the target surface 12, a surface of only a partial region may be a textured surface, and a surface of the remaining region may be a topography such as a polished surface or a bumpy curved surface. Alternatively, as shown in FIG. 8 and FIG. 9, a surface of a complete region of the target surface 12 may be a textured surface. Specifically, a distribution range of the textured surface on the target surface 12 may be determined according to a type of the solar cell and an actual application scenario. This is not specifically limited herein.

For example, as shown in FIG. 8 and FIG. 9, when the solar cell is a double-sided contact cell, a surface of a complete region of the target surface 12 may be a textured surface. Alternatively, as shown in FIG. 11, only a partial region of the target surface 12 may be a textured surface, and a surface of the remaining region of the target surface 12 may be a topography such as a polished surface or a bumpy curved surface.

For example, as shown in FIG. 10, when the solar cell is a back contact cell, alternatively, only a surface of a region in the target surface 12 that corresponds to the first semiconductor layer 14 may be a textured surface, and a surface of the remaining region of the target surface 12 may be a topography such as a polished surface. Alternatively, as shown in FIG. 12, a complete region of the target surface 12 may be a textured surface.

From the perspective of arrangement of the quasi-pyramids, a topography, a size, and distribution of the quasi-pyramids on the textured surface are not specifically limited in this embodiment of the present application, provided that they can be applied to the solar cell provided in this embodiment of the present application.

For example, as shown in FIG. 11 and FIG. 12, the quasi-pyramid 13 may be a pyramid having a sharp vertex angle; or, as shown in FIG. 13, the quasi-pyramid 13 may be a quasi-pyramid 13 having a rounded chamfer; or, as shown in FIG. 14, the quasi-pyramid 13 may be a quasi-pyramid 13 having a truncated vertex angle. In this case, the quasi-pyramid 13 may have at least the foregoing three examples, so that applicability of the solar cell provided in this embodiment of the present application in different application scenarios can be improved. In addition, the manufacturing precision does not need to be strictly controlled to obtain quasi-pyramids 13 having a single topography, thereby reducing the process difficulty, and facilitating an improvement in the yield of the solar cell.

For example, as shown in FIG. 11 and FIG. 12, a surface of the quasi-pyramid 13 may alternatively be a plane. In this case, compared with that the surfaces of the quasi-pyramids are bumpy surfaces, when the surface of the quasi-pyramid 13 is a plane, the surface of the quasi-pyramid 13 is flat, and a fluctuation degree of the quasi-pyramid 13 on the textured surface is low, so that the first semiconductor layer 14 deposited on the textured surface has a large thickness, thereby further improving a high passivation effect of the first semiconductor layer 14. Alternatively, as shown in FIG. 2 to FIG. 4, the surface of the quasi-pyramid 13 may have a bumpy micro-structure, and a position of the micro-structure may correspond to a part of the first semiconductor layer 14 having a larger degree of crystallization.

For example, a one-dimensional size (which may be a side length, a diagonal length, or a height of the base of the quasi-pyramid) of the quasi-pyramid may be greater than or equal to 2 µm and less than or equal to 4 µm. For example, the one-dimensional size of the quasi-pyramid may be 2 µm, 2.2 µm, 2.4 µm, 2.6 µm, 2.8 µm, 3 µm, 3.2 µm, 3.6 µm, 3.8 µm, or 4 µm. In this case, not only the contact area between the first semiconductor layer and the conductive material can be increased by using the quasi-pyramids, but also the textured surface can have a particular light trapping effect, thereby improving the utilization of the semiconductor substrate for light. In addition, that an excessively high treatment temperature affects a passivation effect of the first semiconductor layer because the one-dimensional size of the quasi-pyramid is small to form the first part having a larger degree of crystallization in the first semiconductor layer of a fixed range above the tops of the first quasi-pyramids in the plurality of quasi-pyramids may be avoided; or that an extension range of the first part having a larger degree of crystallization in the first semiconductor layer above the tops of the first quasi-pyramids is large or a crystallization depth of the first part having a larger degree of crystallization in the first semiconductor layer is large under the same treatment condition due to a large one-dimensional size of the first quasi-pyramid may be avoided, thereby ensuring that the first semiconductor layer has a high passivation effect.

For distribution of different quasi-pyramids on the textured surface, it may be understood that there is a larger distance between the top of a quasi-pyramid having a larger height and the base of the quasi-pyramid. However, a contact area between the base of the quasi-pyramid and the semiconductor substrate is large, and the semiconductor substrate has a good heat dissipation effect. Therefore, in a process in which crystallization treatment is performed on at least a part of the first semiconductor layer, a top of a quasi-pyramid having a larger height may dissipate less heat after being heated, and more heat may be more easily accumulated to crystallize the top of the quasi-pyramid. In addition, when crystallization treatment is performed on at least a part of the first semiconductor layer using the laser illumination process, because the quasi-pyramid reflects laser, the reflected laser is more easily concentrated at the top of the quasi-pyramid having a large height, so that the top of the quasi-pyramid having a large height has a higher heat exposure degree, and a part of the first semiconductor layer corresponding to the top of the quasi-pyramid having a large height is more easily crystallized. In addition, when a distribution density of other quasi-pyramids around a single quasi-pyramid is large, the reflected laser is more easily concentrated at the top of the single quasi-pyramid. Based on this, the distribution of different quasi-pyramids in the textured surface may be determined according to a distribution requirement of an actual application scenario for the first part of the first semiconductor layer having a larger degree of crystallization. This is not specifically limited herein.

For the first semiconductor layer, from the perspective of a film layer structure, as shown in FIG. 11 and FIG. 12, the first semiconductor layer 14 may have a single-layer structure. In this case, the first semiconductor layer 14 may include only the first doped semiconductor layer. Alternatively, the first semiconductor layer may be a stack including at least two film layers. For example, as shown in FIG. 15, the first semiconductor layer 14 may include a first intrinsic semiconductor layer 18 and a first doped semiconductor layer 19. The first doped semiconductor layer 19 is arranged on a side of the first intrinsic semiconductor layer 18 that faces away from the semiconductor substrate 11. In this case, the first intrinsic semiconductor layer 18 and the first doped semiconductor layer 19 may form a selective contact structure, which has an excellent interface passivation effect, and can selectively collect carriers, so that a carrier recombination rate of a region on which the first semiconductor layer 14 is formed on the semiconductor substrate 11 is reduced, and the photoelectric conversion efficiency of the solar cell is further improved.

From the perspective of materials, a material of the first semiconductor layer may include only either of amorphous silicon and nanocrystalline silicon, or may include both amorphous silicon and nanocrystalline silicon, provided that the degree of crystallization of the first part of the first semiconductor layer covering at least a part of the top of the quasi-pyramid is greater than the degree of crystallization of the second part of the first semiconductor layer covering the base of the quasi-pyramid.

It should be noted that in the first semiconductor layer, when the degree of crystallization of the first part covering only a part of the top of the quasi-pyramid is greater than the degree of crystallization of the second part of the first semiconductor layer covering the base of the quasi-pyramid, and materials of parts of the first semiconductor layer other than the first part are all amorphous silicon, because the quasi-pyramids are micro-structures on the textured surface, when the quantity of the first quasi-pyramids located below the first part is limited, it may be considered that the material of the first semiconductor layer is only the amorphous silicon. This case should also be considered to be included in the protection scope of the present application.

Secondly, when the first semiconductor layer includes at least two materials, distribution of different materials in the first semiconductor layer may be determined according to degree of crystallizations of different parts of the first semiconductor layer and an actual manufacturing process. This is not specifically limited herein.

For example, as shown in FIG. 2 to FIG. 6, in the first semiconductor layer 14, a material of the first part may include nanocrystalline silicon; and/or, in the first semiconductor layer 14, a material of the second part may include amorphous silicon. In this case, when other factors are the same, compared with nanocrystalline silicon, a degree of crystallization of the amorphous silicon material is lower, and the amorphous silicon material is affected little by heat in a crystallization treatment process, so that the content of hydrogen in the amorphous silicon material is high. Based on this, in the first semiconductor layer 14, when the material of the second part includes amorphous silicon, the second part of the first semiconductor layer 14 that covers at least the bases of the first quasi-pyramids contains much hydrogen, a dangling bond on the surface of the semiconductor substrate is hydrogenated, and surface defects are reduced, thereby having a high passivation effect on the semiconductor substrate. However, in the first semiconductor layer 14, when the material of at least the first part that has a larger degree of crystallization includes nanocrystalline silicon, the first part of the first semiconductor layer 14 has a high electrical conductivity and an effective doping concentration, to reduce a contact resistance between the first part of the first semiconductor layer 14 and a conductive material (a transparent conductive layer or an electrode), and further reduce a transmission loss of transmitting carriers collected in the first semiconductor layer 14 to the conductive material.

For example, as shown in FIG. 2, in the first semiconductor layer 14, a material of a part having a larger degree of crystallization may include nanocrystalline silicon, and a material of a part (including the second part 16 of the first semiconductor layer 14) having a smaller degree of crystallization may be amorphous silicon. For a beneficial effect and an application principle in this case, reference may be made to the foregoing beneficial effect and application principle of the foregoing case that in the first semiconductor layer 14, the material of the part covering at least the base of the quasi-pyramid 13 includes the amorphous silicon, and in the first semiconductor layer 14, the material of at least the part having a larger degree of crystallization includes the nanocrystalline silicon. Details are not described herein again.

In an actual application process, a material of the part of the first semiconductor layer covering the base of the quasi-pyramid may be only the amorphous silicon. In this case, the part of the first semiconductor layer covering the base of the quasi-pyramid has a high passivation effect on the semiconductor substrate. In this case, the material of the first part of the first semiconductor layer that covers the tops of the first quasi-pyramids may be only nanocrystalline silicon, or may include both nanocrystalline silicon and amorphous silicon. In an actual manufacturing process, heat exposure degrees of different regions of the first part of the first semiconductor layer that covers the tops of the first quasi-pyramids are gradually reduced in a direction toward the textured surface. Therefore, a region, far away from the textured surface, of the first part of the first semiconductor layer that covers the tops of the first quasi-pyramids is more easily crystallized. Based on this, when the material of the first part of the first semiconductor layer that covers the tops of the first quasi-pyramids includes nanocrystalline silicon and amorphous silicon, a region of the nanocrystalline silicon material is more easily distributed at the region, far away from the textured surface, of the first part of the first semiconductor layer that covers the tops of the first quasi-pyramids.

Alternatively, in addition to amorphous silicon, a material of the part of the first semiconductor layer covering the base of the quasi-pyramid may further include nanocrystalline silicon. In this case, in the part of the first semiconductor layer covering the base of the quasi-pyramid, and a proportion of nanocrystalline silicon may be less than, equal to, or greater than a proportion of amorphous silicon. In this case, the material of the first part of the first semiconductor layer that covers the tops of the first quasi-pyramids may be only nanocrystalline silicon, or may include both nanocrystalline silicon and amorphous silicon. When the material of the first part of the first semiconductor layer that covers the tops of the first quasi-pyramids includes nanocrystalline silicon and amorphous silicon, reference may be made to the foregoing descriptions for distribution of nanocrystalline silicon and amorphous silicon, and details are not described herein again.

Alternatively, the material of each part of the first semiconductor layer may be nanocrystalline silicon, and the degree of crystallization of nanocrystalline silicon in the first part of the first semiconductor layer covering the tops of the first quasi-pyramids is greater than the degree of crystallization of nanocrystalline silicon in the second part of the first semiconductor layer covering the bases of the first quasi-pyramids.

From the perspective of degree of crystallizations, specific values of degree of crystallizations of the first part of the first semiconductor layer that covers the tops of the first quasi-pyramids and the second part of the first semiconductor layer covering the bases of the first quasi-pyramids are not limited in this embodiment of the present application. It may be understood that, as described above, when the degree of crystallization of the first part of the first semiconductor layer covering the tops of the first quasi-pyramids is large, an electrical conductivity of the first part of the first semiconductor layer covering the tops of the first quasi-pyramids is increased, a contact resistance between the first semiconductor layer and a conductive material (a transparent conductive layer or an electrode) is reduced, and a transmission loss of transmitting carriers collected in the first semiconductor layer to the conductive material is further reduced. In addition, in the first semiconductor layer, at least the second part has a small degree of crystallization. In a case of crystallization treatment at a reduced temperature, at least the second part has a high content of hydrogen, so that at least the second part has a high passivation effect on the textured surface. Therefore, degree of crystallizations, grain sizes, crystallization depths, and the like of different parts of the first semiconductor layer may be determined according to requirements for a passivation effect and a transmission loss of the first semiconductor layer in an actual application scenario.

From the perspective of a grain size, a first part of the first semiconductor layer includes grains, and a maximum size of the grains may be equal to a thickness of the first part. In this case, the first part of the first semiconductor layer has high conductivity. This can further reduce transmission loss of transmitting carriers collected in the first semiconductor layer to a conductive material.

Alternatively, as shown in FIG. 2, the maximum size of the grains in the first part of the first semiconductor layer 14 may be less than the thickness of the first part. In this case, during actual manufacturing, a larger size of grains in the first part of the first semiconductor layer 14 indicates a higher temperature for performing crystallization treatment on the first part of the first semiconductor layer 14. However, a higher treatment temperature indicates a larger amount of evolved hydrogen in the first part of the first semiconductor layer 14, and consequently, the passivation effect of the first part of the first semiconductor layer 14 on the semiconductor substrate is reduced. Therefore, compared with that the size of the grains in the first part of the first semiconductor layer 14 is equal to the thickness of the first part, when the size of grains in the first part of the first semiconductor layer 14 is less than the thickness of the first part, crystallization temperature corresponding to the first semiconductor layer 14 is low, so that the first part of the first semiconductor layer 14 has high electrical conductivity and an effective doping concentration, and a transmission loss between the first part of the first semiconductor layer 14 and the conductive material is reduced. In this way, a part, in which no grain extendedly grows, of the first semiconductor layer 14 has a passivation effect on the semiconductor substrate, and a balance between the passivation effect and the transmission loss that correspond to the first semiconductor layer 14 is achieved, to further improve work performance of the solar cell.

A specific value of the size of grains in the first semiconductor layer may be determined according to the thickness of the first semiconductor layer, and requirements for a passivation effect and a transmission loss of the first semiconductor layer in an actual application scenario. This is not specifically limited herein.

For example, the size of the grains in the first semiconductor layer may be less than or equal to 50 nm. For example, the size of the grains in the first semiconductor layer may be 1 nm, 2 nm, 4 nm, 6 nm, 8 nm, 10 nm, 12 nm, 15 nm, 18 nm, 20 nm, 30 nm, 40 nm, or 50 nm.

From the perspective of crystallization depths, the crystallization depth of the first part of the first semiconductor layer may be equal to the thickness of the first part. Alternatively, the crystallization depth of the first part of the first semiconductor layer may be less than the thickness of the first part. For a beneficial effect and an application principle in this case, reference may be made to the foregoing beneficial effect and application principle that the size of the grains in the first part of the first semiconductor layer is less than the thickness of the first part, and details are not described herein again.
crystallization depths of regions of the first part of the first semiconductor layer may be the same. Alternatively, as shown in FIG. 2, a crystallization depth of the first part (that is, the part having a larger degree of crystallization) of the first semiconductor layer 14 is gradually reduced along a direction from the laterally inclined direction of the first quasi-pyramid to the bases of the first quasi-pyramids. In this case, when crystallization treatment is performed on at least a part of the first semiconductor layer 14, a treatment temperature of each part of the first semiconductor layer 14 covering the quasi-pyramid 13 is gradually reduced along the direction from the laterally inclined direction of each of the quasi-pyramids 13 to the base of the quasi-pyramid 13. When the first part of the first semiconductor layer 14 having a larger degree of crystallization has high electrical conductivity and an effective doping concentration, impact of a high temperature of the crystallization treatment on the remaining part of the first semiconductor layer 14 is reduced, to ensure that the remaining part of the first semiconductor layer 14 has a high hydrogen content, so that the remaining part of the first semiconductor layer 14 has a high passivation effect on the semiconductor substrate 11.

It can be learned from the above that, different grain sizes and crystallization depths of the part of the first semiconductor layer covering the tops of the first quasi-pyramids correspond to different beneficial effects respectively. A suitable grain size and crystallization depth may be obtained by adjusting a manufacturing parameter according to a requirement of an actual application scenario, thereby improving applicability of the solar cell provided in this embodiment of the present application to different application scenarios. In addition, when the first semiconductor layer includes the first intrinsic passivation layer and the first doped semiconductor layer, and the crystallization depth is less than the thickness of the first part, the maximum crystallization depth of the first part of the first semiconductor layer having a larger degree of crystallization along the direction toward the textured surface may be less than or equal to the thickness of the first doped semiconductor layer. In this case, the part of the first semiconductor layer that corresponds to the first intrinsic semiconductor layer and that has a larger degree of crystallization still has a passivation effect on the semiconductor substrate, which can further reduce the carrier recombination rate. The grain size of the first part of the first semiconductor layer having a larger degree of crystallization along the direction toward the textured surface may be less than or equal to the thickness of the first doped semiconductor layer.

In addition, in an actual application process, the first part that in the first semiconductor layer that has a larger degree of crystallization may be arranged above tops of only some quasi-pyramids included in the textured surface (that is, in this case, the plurality of quasi-pyramids further includes the remaining quasi-pyramids in addition to the first quasi-pyramids), or may be arranged above tops of all the quasi-pyramids included in the textured surface (that is, in this case, the plurality of quasi-pyramids includes only the first quasi-pyramids). The number of the first quasi-pyramids corresponding to the first part in the first semiconductor layer that has a larger degree of crystallization may be determined according to distribution and heights of different quasi-pyramids in an actual manufacturing process. In addition, as described above, although the first part in the first semiconductor layer that has a larger degree of crystallization may reduce the transmission loss between the first semiconductor layer and the conductive material, the first part in the first semiconductor layer that has a larger degree of crystallization has a weak passivation effect on the semiconductor substrate (compared with the second part in the first semiconductor layer that has a smaller degree of crystallization). Based on this, an arrangement range of the first part in the first semiconductor layer that has a larger degree of crystallization at the tops of the first quasi-pyramids may be determined according to requirements for a passivation effect and a transmission loss that correspond to the first semiconductor layer in an actual application scenario. This is not specifically limited herein.

For example, when the ratio of the maximum extension length of the first part of the first semiconductor layer on the side of each of the first quasi-pyramids located below the first part to the length of the side of each of the first quasi-pyramids may be less than or equal to 0.3 along the laterally inclined direction of the first quasi-pyramid. For example, the ratio of the maximum extension length of the first part of the first semiconductor layer on the side of each of the first quasi-pyramids located below the first part to the length of the side of each of the first quasi-pyramids may be 0.05, 0.1, 0.15, 0.2, 0.25, or 0.3. In this case, the first part in the first semiconductor layer can have a large coverage of the textured surface, thereby further reducing the quantity of surface defects of the textured surface. In addition, in an actual manufacturing process, a heating rate of the top of the quasi-pyramid is higher than a heating rate of the base of the quasi-pyramid, and more heat is more easily accumulated at the top of the quasi-pyramid, so that the quasi-pyramid has a higher degree of crystallization. Based on this, when the ratio of the maximum extension length of the first part of the first semiconductor layer on the side of each of the first quasi-pyramids located below the first part to the length of the side of each of the first quasi-pyramids is less than or equal to 0.3 along the laterally inclined direction of the first quasi-pyramid, a case that an extension length of the first part of the first semiconductor layer above the first quasi-pyramid is large and consequently the first part of the first semiconductor layer that is at the tops of the first quasi-pyramids is excessively hot to affect the passivation effect of the first semiconductor layer can be avoided, to ensure that the first part of the first semiconductor layer that is at the tops of the first quasi-pyramids also has a particular passivation effect, thereby further improving the work efficiency of the solar cell.

From the perspective of conductivity types, the conductivity type of the first doped semiconductor layer included in the first semiconductor layer is not limited in this embodiment of the present application. Specifically, the conductivity type of the first doped semiconductor layer included in the first semiconductor layer may be opposite to or the same as the conductivity type of the semiconductor substrate.

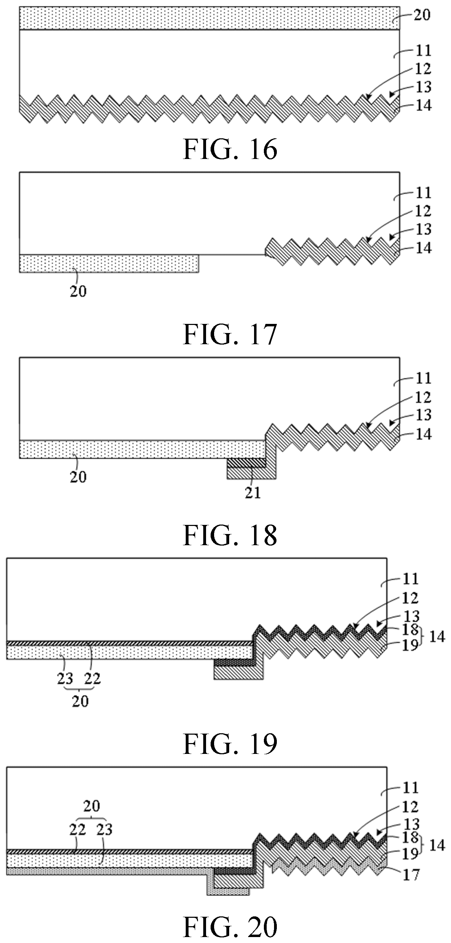

In addition, when the first surface and the second surface of the semiconductor substrate are not target surfaces simultaneously, as shown in FIG. 15 and FIG. 16, the solar cell may further include a second semiconductor layer 20 having a conductivity type opposite to that of the first semiconductor layer 14. A arrangement position of the second semiconductor layer 20 on the semiconductor substrate 11 may be set according to a type of the solar cell and an actual requirement. This is not specifically limited herein.

Specifically, as shown in FIG. 16, the first semiconductor layer 14 and the second semiconductor layer 20 are respectively arranged on two opposite surfaces of the semiconductor substrate 11 when the solar cell is a double-sided contact cell.

Alternatively, as shown in FIG. 15, the second semiconductor layer 20 and the first semiconductor layer 14 are arranged on a same surface of the semiconductor substrate 11 when the solar cell is a back contact cell. In this case, the solar cell provided in this embodiment of the present application is a back contact cell, which can reduce impact of a light-shielding electrode structure on the utilization of light on a side of a light receiving surface, and further improve the photoelectric conversion efficiency of the solar cell. In this case, as shown in FIG. 17, the first semiconductor layer 14 and the second semiconductor layer 20 may be distributed at an interval along a direction parallel to the target surface 12. Alternatively, as shown in FIG. 15, the first semiconductor layer 14 may extend to cover a part of the second semiconductor layer 20 that faces away from a side of the semiconductor substrate 11. In this case, the first semiconductor layer 14 may be formed by selectively etching a first semiconductor material that is used for manufacturing the first semiconductor layer 14 and that is arranged in a whole layer, which is beneficial to improving the manufacturing efficiency of the solar cell.

As shown in FIG. 18 and FIG. 19, when the first semiconductor layer 14 extends to cover a part of the second semiconductor layer 20 that faces away from a side of the semiconductor substrate 11, the part of the first semiconductor layer 14 extending to the second semiconductor layer 20 may be isolated by using an insulation layer 21 such as silicon oxide or silicon nitride, or the first doped semiconductor layer 19 included in the first semiconductor layer 14 may be isolated by using the first intrinsic semiconductor layer 18. Specifically, when the first doped semiconductor layer 19 included in the first semiconductor layer 14 is isolated by using the first intrinsic semiconductor layer 18, it may be understood that the thickness of the first intrinsic semiconductor layer 18 not only affects a transmission loss of transmitting carriers to the first doped semiconductor layer 19 through the first intrinsic semiconductor layer 18, but also affects a passivation effect of the first intrinsic semiconductor layer 18, and further affects a leakage isolation effect of the first intrinsic semiconductor on the first doped semiconductor layer 19 and the second semiconductor layer 20. Based on this, on the premise that the first part of the first semiconductor layer 14 that covers the tops of the first quasi-pyramids and that has a larger degree of crystallization has high electrical conductivity to reduce a transmission loss between the first part and a conductive material, while the work efficiency of the solar cell provided in this embodiment of the present application is not reduced compared with the work efficiency of an existing solar cell, the arrangement of the first part having a larger degree of crystallization can reserve adjustable space for increasing the thickness of the first intrinsic semiconductor layer 18, which not only can further suppress electrical leakage between the first doped semiconductor layer 19 and the second semiconductor layer 20 by means of the first intrinsic semiconductor layer 18 having a large thickness, but also can improve the passivation effect of the first intrinsic semiconductor layer 18 on the semiconductor substrate 11, and can reduce the carrier recombination rate.

Specifically, as shown in FIG. 18, the second semiconductor layer 20 may have a single-layer structure. In this case, the second semiconductor layer 20 may include only the second doped semiconductor layer. Alternatively, the second semiconductor layer may be a stack including at least two film layers. For example, as shown in FIG. 19, the second semiconductor layer 20 may include an interface passivation layer 22 and a second doped semiconductor layer 23. The second doped semiconductor layer 23 is arranged on a side of the interface passivation layer 22 that faces away from the semiconductor substrate 11. In this case, the interface passivation layer 22 and the second doped semiconductor layer 23 may form a selective contact structure, which has an excellent interface passivation effect, and can selectively collect carriers, so that a carrier recombination rate of a region on which the second semiconductor layer 20 is formed on the semiconductor substrate 11 is reduced, and the photoelectric conversion efficiency of the solar cell is further improved.

From the perspective of materials, a material of the second semiconductor layer may be the same as or different from a material of the first semiconductor layer. When materials of the second semiconductor layer and the first semiconductor layer are different, the material of the second semiconductor layer may include any semiconductor material different from that of the first semiconductor layer. For example, a material of the second semiconductor layer may include at least one of polycrystalline silicon, amorphous silicon, nanocrystalline silicon, and microcrystalline silicon. In this case, there is a plurality of possible examples of a material of the second semiconductor layer, so that applicability of the solar cell provided in the present application in different application scenarios can be improved.

In an embodiment, when the solar cell provided in this embodiment of the present application is a back contact cell, the first semiconductor layer includes a first intrinsic semiconductor layer and a first doped semiconductor layer, and the second semiconductor layer includes an interface passivation layer and a second doped semiconductor layer. The interface passivation layer includes a tunneling passivation layer, and the second doped semiconductor layer includes a doped polycrystalline silicon layer.

As far as the surface topography of the second semiconductor layer on which the semiconductor substrate is formed, the surface topography corresponding to the semiconductor substrate and the second semiconductor layer is not specifically limited in this embodiment of the present application. For example, the surface topography corresponding to the semiconductor substrate and the second semiconductor layer may be a polished surface, a textured surface, or a bumpy curved surface. When the surface topography corresponding to the semiconductor substrate and the second semiconductor layer is a textured surface, and the material of the second semiconductor layer includes amorphous silicon and/or nanocrystalline silicon, the degree of crystallization of the first part of the second semiconductor layer covering at least a part of the top of the quasi-pyramid may be greater than the degree of crystallization of the second part of the second semiconductor layer covering the base of the quasi-pyramid; or the parts of the second semiconductor layer may have approximately the same degree of crystallization. Specifically, when the degree of crystallization of the first part of the second semiconductor layer covering at least a part of the top of the quasi-pyramid may be greater than the degree of crystallization of the second part of the second semiconductor layer covering the base of the quasi-pyramid, reference may be made to corresponding cases of the first part and the second part included in the foregoing first semiconductor layer for features such as degree of crystallizations, grain sizes, and crystallization depths of the first part and the second part of the second semiconductor layer, and distribution of the first part. Details are not described herein again.

It should be noted that when the conductivity type of the first doped semiconductor layer included in the first semiconductor layer is the same as the conductivity type of the semiconductor substrate, the solar cell includes the second semiconductor layer. However, when the conductivity type of the first doped semiconductor layer included in the first semiconductor layer is opposite to the conductivity type of the semiconductor substrate, the solar cell may include the second semiconductor layer, or may not include the second semiconductor layer.

As for the thickness of the first semiconductor layer, the thickness of the first semiconductor layer is not specifically limited in this embodiment of the present application, and may be determined according to a type of the solar cell in an actual application scenario, and requirements for a passivation effect and a transmission loss of the first semiconductor layer.

For example, a thickness of the first semiconductor layer may be greater than or equal to 10 nm, and/or a thickness of the first semiconductor layer is less than or equal to 45 nm. For example, the first semiconductor layer may have a thickness of 10 nm, 12 nm, 15 nm, 20 nm, 25 nm, 30 nm, 35 nm, 40 nm, or 45 nm. In this case, a lower limit and/or an upper limit of the thickness of the first semiconductor layer of which the material includes the amorphous silicon and/or the nanocrystalline silicon is larger, which reduces thermal impact of heat on the semiconductor substrate by using the first semiconductor layer having a larger thickness, thereby preventing thermal damage from being caused to the semiconductor substrate in a process in which crystallization treatment is performed on at least a part of the first semiconductor layer, and ensuring that the solar cell has a high yield. In addition, the first semiconductor layer having a larger thickness has a high passivation effect, which can further reduce a carrier recombination rate at the textured surface, thereby further improving the work efficiency of the solar cell.

From the perspective of surface topography, parts of the surface of the side of the first semiconductor layer facing away from the semiconductor substrate may have approximately the same surface roughness. Alternatively, as shown in FIG. 2, a surface roughness of the first part of the first semiconductor layer 14 may be greater than a surface roughness of the second part. In this case, the first part of the first semiconductor layer 14 has a larger specific surface area, which increases the contact area between the first part and the conductive material, reduces the contact resistance between the first part and the conductive material, further reduces the transmission loss of transmitting the carriers to the conductive material through the first semiconductor layer 14, and further improves the work efficiency of the solar cell. In addition, in an actual manufacturing process, laser illumination, high-temperature annealing, or the like needs to be used to implement crystalline modification of a part of the first semiconductor layer 14. However, a heating rate of the top of the quasi-pyramid 13 is higher than a heating rate of the base of the quasi-pyramid, and crystalline modification is easier to be implemented. In addition, the change of the surface roughness of the first part is related to the change of the degree of crystallization of the first part and the evolution of hydrogen in the first part. Based on this, when the surface roughness of the first part is greater than the surface roughness of the second part, each part of the first semiconductor layer 14 does not need to be heated for a long time to cause the second part of the first semiconductor layer 14 covering the bases of the first quasi-pyramids to also have a large surface roughness, which otherwise causes dehydrogenation, thereby ensuring a high passivation effect of the first semiconductor layer 14. In this case, a difference between the surface roughness of the first part and the surface roughness of the second part may be determined according to a difference between the degree of crystallizations of the first part and the second part and an actual application scenario, and details are not described herein again.

In a possible implementation solution, as shown in FIG. 20, the solar cell may further include a transparent conductive layer 17, and the transparent conductive layer 17 covers at least a side of the first semiconductor layer 14 that faces away from the semiconductor substrate 11. In this case, the transparent conductive layer 17 has a high conductivity, so that carriers collected by the first semiconductor layer 14 may be exported in time, thereby reducing a carrier recombination rate.

In an actual application process, a material and a thickness of the transparent conductive layer are not specifically limited in the embodiments of the present application, provided that they can be applied to the solar cell provided in this embodiment of the present application. It should be noted that, when the solar cell provided in this embodiment of the present application is a back contact cell, the transparent conductive layer may cover only a side of the first semiconductor layer that faces away from the semiconductor substrate. Alternatively, as shown in FIG. 20, the transparent conductive layer 17 not only covers a side of the first semiconductor layer 14 that faces away from the semiconductor substrate 11, but also covers a side of the second semiconductor layer 20 that faces away from the semiconductor substrate 11, and the transparent conductive layer 17 is provided with an insulation groove, to separate parts of the transparent conductive layer 17 respectively covering the first semiconductor layer 14 and the second semiconductor layer 20, thereby preventing short circuiting.

According to a second aspect, an embodiment of the present application provides a manufacturing method for a solar cell. The manufacturing method for a solar cell includes the following steps: First, a semiconductor substrate is provided. The semiconductor substrate has a first surface and a second surface that are opposite to each other. At least one of the first surface and the second surface is a target surface. A surface of at least a partial region of the target surface is a textured surface. The textured surface includes a plurality of quasi-pyramids, and the plurality of quasi-pyramids includes first quasi-pyramids. Next, a first semiconductor layer is formed on the textured surface, where a material of the first semiconductor layer includes amorphous silicon and/or nanocrystalline silicon. The first semiconductor layer includes a first part covering tops of the first quasi-pyramids and a second part covering bases of the first quasi-pyramids, and a degree of crystallization of the first part is greater than a degree of crystallization of the second part.

Specifically, for information about the structure, the material, and the like of the solar cell manufactured by using the manufacturing method provided in this embodiment of the present application, reference may be made to the description about the structure, the material, and the like of the solar cell provided in the foregoing first aspect, and details are not described herein again.

A specific process of forming the first semiconductor layer may be determined according to a type of a manufactured solar cell.

For example, if the manufactured solar cell is a double-sided contact cell, after the textured surface is formed on at least a partial region of the target surface of the semiconductor substrate, a process such as chemical vapor deposition may be used to form the entire first semiconductor material layer arranged on the target surface. If only a partial region of the target surface is a textured surface, the first semiconductor material layer may be selectively etched by using a process such as laser or wet etching after the first semiconductor material layer is formed, to remove a part of the first semiconductor material layer that does not correspond to the textured surface. If a complete region of the target surface is a textured surface, the first semiconductor material layer arranged in a whole layer is the first semiconductor layer. Then, after the first semiconductor layer is obtained, crystallization treatment may be performed on at least a part of the first semiconductor layer by using a laser illumination process, to cause a degree of crystallization of the first part of the first semiconductor layer to be greater than a degree of crystallization of the second part. Specifically, the first semiconductor layer generates heat after absorbing light, causing a temperature of the first semiconductor layer to increase. After the temperature increases to a certain extent, the first semiconductor layer may be in a crystalline state. In addition, because of reflection of the laser on the surface of the quasi-pyramid and a difference between heat dissipation speeds in different locations on the quasi-pyramid (a heat dissipation speed at the top of the quasi-pyramid is lower, and a heat dissipation speed at the base of the quasi-pyramid is higher), the temperature of the first part of the first semiconductor layer that covers the tops of the first quasi-pyramids is higher than the temperature of a part in another location. Therefore, the first part of the first semiconductor layer that covers the tops of the first quasi-pyramids has a larger degree of crystallization.

Specifically, parameters such as a treatment wave length, a pulse width, a laser energy density, and a treatment time of the laser illumination process may be determined according to a requirement in an actual application scenario, such as an extension range of the first part of the first semiconductor layer that covers the tops of the first quasi-pyramids and that has a larger degree of crystallization. This is not specifically limited herein. It may be understood that, when the laser illumination process has a smaller treatment wave length, a larger pulse width, a higher laser energy density, and a longer treatment time, and the laser illumination process is used to treat the first semiconductor layer, a larger temperature increase degree of the first semiconductor layer is more beneficial to forming the first part having a larger crystallization depth and a larger extension length.

For example, the treatment wave length of the laser illumination process may be greater than or equal to 325 nm and less than or equal to 532 nm. For example, the treatment wave length may be 325 nm, 330 nm, 350 nm, 80 nm, 400 nm, 430 nm, 450 nm, 480 nm, 500 nm, or 532 nm.

For example, a pulse width of the laser illumination process may be on an order of picoseconds or nanoseconds. For example, the pulse width may be 10 ps, 50 ps, 100 ps, 300 ps, 500 ps, 800 ps, 1 ns, or 5 ns.

For example, a laser energy density of the laser illumination process may be greater than or equal to 200 mJ/cm² and less than or equal to 6000 mJ/cm². For example, the laser energy density may be 200 mJ/cm², 240 mJ/cm², 280 mJ/cm², 300 mJ/cm², 400 mJ/cm², 500 mJ/cm², 1000 mJ/cm², 2000 mJ/cm², 3000 mJ/cm², 4000 mJ/cm², 5000 mJ/cm², or 6000 mJ/cm².

In addition, when the manufactured solar cell is a double-sided contact cell, if the solar cell further includes a second semiconductor layer, before or after the first semiconductor layer is formed, the second semiconductor layer may be formed on a side of the semiconductor substrate facing away from the first semiconductor layer by using at least a doping process.

For example, when the manufactured solar cell is a back contact cell, if the first semiconductor layer and the second semiconductor layer are distributed at an interval along the direction parallel to the first surface, the first semiconductor layer and the second semiconductor layer may be separately formed in the foregoing manner of forming the first semiconductor layer on a partial region of the target surface. Then, crystallization treatment may be performed on at least a part of the first semiconductor layer by using a laser illumination process, to cause a degree of crystallization of the first part of the first semiconductor layer covering the tops of the first quasi-pyramids to be greater than a degree of crystallization of the second part of the first semiconductor layer covering the bases of the first quasi-pyramids. If the first semiconductor layer extends to cover a part of the second semiconductor layer, after the second semiconductor material layer arranged on the target surface entire in a whole layer may be formed by using a deposition process and a doping process, a part of the second semiconductor material layer is selectively removed by using a process such as laser or wet etching, to expose a region of the semiconductor substrate that is used for manufacturing the first semiconductor layer. Then, under a mask action of a corresponding mask layer, texturing treatment is performed on at least a region of the semiconductor substrate that is used for manufacturing the first semiconductor layer, so that a surface of a partial region of the target surface form a textured surface. Then, the first semiconductor layer may be formed in the foregoing manner, and the degree of crystallization of the first part of the first semiconductor layer covering the tops of the first quasi-pyramids is greater than the degree of crystallization of the second part of the first semiconductor layer covering the bases of the first quasi-pyramids. For parameter settings of the laser illumination process in this case, reference may be made to the foregoing descriptions, and details are not described herein again.

In some other embodiments of the present application, a solar cell is further provided. As shown in FIG. 14, the solar cell includes a semiconductor substrate 11 (for example, a silicon substrate), and a side surface of the semiconductor substrate 11 includes a first region, a second region, and a third region that are sequentially adjacent to each other.

In the first region, a first doped layer (namely, a first semiconductor layer 14) and a first electrode 141 are sequentially stacked on the semiconductor substrate 11. In the third region, a second doped layer (namely, a second semiconductor layer 20) and a second electrode 142 are sequentially stacked on the semiconductor substrate 11. Conductivity of the first doped layer is opposite to conductivity of the second doped layer.

At least one of the first doped layer in the first region and the second doped layer in the third region has a crystallization zone. A projection of the crystallization zone on the semiconductor substrate 11 at least partially overlaps with a projection of the first electrode 141 on the semiconductor substrate 11, and/or the projection of the crystallization zone on the semiconductor substrate 11 at least partially overlaps with a projection of the second electrode 142 on the semiconductor substrate 11.

In addition, the first doped layer and the second doped layer extend to the second region. In the second region, at least a part of the first doped layer is an amorphous zone, and at least a part of the second doped layer is an amorphous zone.

In the solar cell provided in this embodiment, because photon-generated carriers perform lateral transfer and diffusion (in a direction perpendicular to a thickness direction of a doped layer) and longitudinal transfer and diffusion (in a direction parallel to a thickness direction of a doped layer) in doped layers of different doping types, in the present application, the second region with high resistivity is arranged between the first doped layer in the first region and the second doped layer in the third region for isolation, so that lateral transfer of carriers can be reduced, and leakage can be reduced. In addition, at least one of the first doped layer in the first region and the second doped layer in the third region has a crystallization zone, and the crystallization zone has good conductivity, facilitating carrier collection. In addition, in the second region, at least a part of the first doped layer is an amorphous zone, and at least a part of the second doped layer is an amorphous zone. The amorphous zone has lower carrier mobility and lower sheet resistance than the crystallization zone, so that a leakage current can be greatly reduced.

The silicon substrate includes a light-receiving surface and a non-illuminated surface that are distributed opposite to each other. The non-illuminated surface of the silicon substrate includes a first region, a second region, and a third region that are sequentially adjacent to each other. The being adjacent herein means that the first region, the second region, and the third region are sequentially connected to each other without overlapping.

All of the silicon substrate, the first doped layer, and the second doped layer have a textured structure. Alternatively, all of the silicon substrate, the first doped layer, and the second doped layer have a smooth surface. Alternatively, the silicon substrate and the first doped layer in the first region have a textured surface, and all functional layers in the third region have a smooth surface. Alternatively, the silicon substrate and the first doped layer in the first region have a smooth surface, and all functional layers in the third region have a textured structure.

In some implementations, when the first doped layer in the first region has a textured surface, only a protruding part of the textured surface in the laser illumination region undergoes crystal transformation, and a recessed part does not undergo crystal transformation.

In some implementations, when the second doped layer in the third region has a textured surface, only a protruding part of the textured surface in the laser illumination region undergoes crystal transformation, and a recessed part does not undergo crystal transformation.

In the solar cell shown in FIG. 14, in the first region, the first doped layer includes a first crystallization zone 152 and a first amorphous zone A 156. At least a part on a side, away from the silicon substrate, in the first crystallization zone 152 has crystal. In the third region, the second doped layer includes a second crystallization zone 155. In the second region, at least a side, close to the first region, of the first doped layer is a first amorphous zone B 158; and at least a side, close to the first region, of the second doped layer is a second amorphous zone B 157. A light-entrance-surface passivation layer and an anti-reflective layer are sequentially formed on the light-receiving surface of the silicon substrate.

The manufacturing method for a solar cell in this embodiment includes the following steps. Step 1: Polish and clean a silicon sheet, and texture a light entrance surface.

Step 2: Sequentially deposit a 5-nm intrinsic hydrogenated amorphous silicon passivation layer, a 30-nm amorphous n layer, a 100-nm SiNx layer (with a refractive index of 2.5), and a 30-nm laser absorbing layer on a rear surface of the solar cell through PECVD.

Step 3: Remove a laser absorbing layer in a first region by using a laser, to form a laser opening and expose a SiNx layer.

Step 4: Perform a wet process: Use hydrofluoric acid with a concentration of 10% to remove the SiNx layer in the laser opening, to expose an amorphous n layer; and use potassium hydroxide with a concentration of 10% to remove the exposed amorphous n layer, an intrinsic hydrogenated amorphous silicon passivation layer below the exposed amorphous n layer, and a laser absorbing layer in a second region and a third region, to expose a silicon sheet in the first region and a silicon nitride layer in the second region and the third region.

Step 5: On the rear surface of the solar cell, sequentially deposit a 5-nm intrinsic hydrogenated amorphous silicon passivation layer and a 30-nm amorphous p layer on the silicon sheet in the first region and on the silicon nitride layer in the second region and the third region by using the PECVD technology.

Step 6: Remove an amorphous p layer and an intrinsic hydrogenated amorphous silicon passivation layer in the third region by using a laser (single-spot energy density of the laser is 200 mJ/cm²) to form an opening, to expose a SiNx layer in the third region.

Step 7: Perform wet treatment: Use hydrofluoric acid with a concentration of 10% to remove the SiNx layer in the third region.

Step 8: Deposit a light-entrance-surface intrinsic hydrogenated amorphous silicon passivation layer and a SiNx anti-reflective film with a refractive index of 2 and a thickness of 70 nm through PECVD.

Step 9: Perform laser crystallization treatment: Crystallize a middle region of an amorphous p layer in the first region into a nanocrystalline p-type region by using a laser. To be specific, the first region includes both a first nanocrystalline silicon p-doped region and a first amorphous silicon p-doped region. The first amorphous silicon p-doped region surrounds the first nanocrystalline silicon p-doped region. A part at which an amorphous n layer in the third region is stacked with an electrode is crystallized into a nanocrystalline n-type region.

Step 10: Sequentially deposit a TCO layer and an Ag electrode (a first electrode 141) on a nanocrystalline p layer, and sequentially deposit a TCO layer and an Ag electrode (a second electrode 142) on a nanocrystalline n layer.

In the descriptions of the foregoing implementations, the described specific features, structures, materials, or characteristics may be combined in a proper manner in any one or more of the embodiments or examples.

For beneficial effects of the second aspect and various implementations of the second aspect of this embodiment of the present application, reference may be made to analysis of the beneficial effects of the first aspect and the implementations of the first aspect, and details are not described herein again.

In the foregoing description, technical details such as patterning and etching of the layers are not described in detail. However, a person skilled in the art should understand that a layer, a region, and the like of a required shape may be formed by using various technical means. In addition, to form a same structure, a person skilled in the art may further design a method that is not completely the same as the method described above. In addition, although the embodiments are respectively described above, it does not mean that measures in the embodiments cannot be advantageously combined for use.

The embodiments of the present application are described above. However, these embodiments are merely for clearer description and are not intended to limit the scope of the present application. Therefore, the scope of the present application is subject to the claims and equivalents thereof. A person skilled in the art may make various replacements and modifications without departing from the scope of the present application, and these replacements and modifications shall fall within the scope of the present application.

## Claims

1. A solar cell, comprising:
a semiconductor substrate, wherein the semiconductor substrate comprises a first surface and a second surface that are opposite to each other; at least one of the first surface and the second surface is a target surface; and a surface of at least a partial region of the target surface is a textured surface, and the textured surface comprises a plurality of quasi-pyramids; and
a first semiconductor layer, arranged on the textured surface, wherein a material of the first semiconductor layer comprises amorphous silicon and/or nanocrystalline silicon; and the plurality of quasi-pyramids comprises first quasi-pyramids, the first semiconductor layer comprises a first part covering tops of the first quasi-pyramids and a second part covering bases of the first quasi-pyramids, and a degree of crystallization of the first part is greater than a degree of crystallization of the second part.

2. The solar cell according to claim 1, wherein the first part contains grains, and a maximum size of the grains is less than a thickness of the first part.

3. The solar cell according to claim 1, wherein along a laterally inclined direction of each of the quasi-pyramids, a ratio of a maximum extension length of the first part on a side of each of the first quasi-pyramids located below the first part to a length of the side of each of the first quasi-pyramids is less than or equal to 0.3.

4. The solar cell according to claim 1, wherein a thickness of the first semiconductor layer is greater than or equal to 10 nm, and/or a thickness of the first semiconductor layer is less than or equal to 45 nm.

5. The solar cell according to claim 1, wherein the solar cell further comprises a transparent conductive layer, and the transparent conductive layer covers at least a side of the first semiconductor layer that faces away from the semiconductor substrate.

6. The solar cell according to claim 1, wherein the quasi-pyramids are pyramids having a sharp vertex angle;
or the quasi-pyramids are quasi-pyramids having a rounded chamfer;
or the quasi-pyramids are quasi-pyramids having a truncated vertex angle.

7. The solar cell according to claim 1, wherein surfaces of the quasi-pyramids are planes; and/or a surface roughness of the first part is greater than a surface roughness of the second part.

8. The solar cell according to any one of claims 1 to 7, wherein the first semiconductor layer comprises a first intrinsic semiconductor layer and a first doped semiconductor layer; and the first doped semiconductor layer is arranged on a side of the first intrinsic semiconductor layer that faces away from the semiconductor substrate; and
along a direction toward the textured surface, the maximum size of the grains contained in the first part is less than or equal to a thickness of the first doped semiconductor layer.

9. The solar cell according to any one of claims 1 to 7, wherein the solar cell further comprises a second semiconductor layer having a conductivity type opposite to that of the first semiconductor layer, wherein
the second semiconductor layer and the first semiconductor layer are arranged on a same surface of the semiconductor substrate, and the first semiconductor layer extends to cover a part of a side of the second semiconductor layer that faces away from the semiconductor substrate; and/or the second semiconductor layer is arranged on the second surface of the semiconductor substrate, and a material of the second semiconductor layer comprises at least one of polycrystalline silicon, amorphous silicon, nanocrystalline silicon, and microcrystalline silicon.

10. The solar cell according to any one of claims 1 to 7, wherein a material of the first part comprises nanocrystalline silicon; and a material of the second part is amorphous silicon.

11. A manufacturing method for a solar cell, comprising:
providing a semiconductor substrate, wherein the semiconductor substrate has a first surface and a second surface that are opposite to each other; at least one of the first surface and the second surface is a target surface; a surface of at least a partial region of the target surface is a textured surface; the textured surface comprises a plurality of quasi-pyramids; and the plurality of quasi-pyramids comprises first quasi-pyramids; and
forming a first semiconductor layer on the textured surface, wherein a material of the first semiconductor layer comprises amorphous silicon and/or nanocrystalline silicon; and the first semiconductor layer comprises a first part covering tops of the first quasi-pyramids and a second part covering bases of the first quasi-pyramids, and a degree of crystallization of the first part is greater than a degree of crystallization of the second part.

12. The manufacturing method for a solar cell according to claim 11, wherein performing crystallization treatment on at least a part of the first semiconductor layer by using a laser illumination process, to cause a degree of crystallization of the first part to be greater than a degree of crystallization of the second part.

13. The manufacturing method for a solar cell according to claim 12, wherein a wave length of laser used in the laser illumination process is greater than or equal to 325 nm and less than or equal to 532 nm;
and/or a pulse width of the laser illumination process is on an order of picoseconds or nanoseconds;
and/or a laser energy density of the laser illumination process is greater than or equal to 200 mJ/cm² and less than or equal to 6000 mJ/cm².
